# FASCICULE DE BREVET EUROPEEN

(11) **EP 3 063 183 B1**
(45) Date de publication et mention de la délivrance du brevet: **11.10.2017**
(21) Numéro de dépôt: 14825388.3
(22) Date de dépôt: 29.10.2014
(51) Int. Cl.: C08F 4/00, C09K 11/00, C08G 61/12, H01B 1/00, H01L 51/00

(54) **COMPOSITIONS STABLES DE NANOTUBES DE CARBONE - POLYMERES ELECTROLYTES**
STABILE ZUSAMMENSETZUNGEN MIT KOHLENSTOFFNANORÖHREN UND POLYMERELEKTROLYTEN
STABLE COMPOSITIONS COMPRISING CARBON NANOTUBES AND POLYMER ELECTROLYTES

(30) Priorité: 31.10.2013 FR 1360685
(43) Date de publication de la demande: 07.09.2016
(73) Titulaire: Arkema France, 92700 Colombes (FR); Centre National de la Recherche Scientifique, 75794 Paris Cedex 16 (FR); Université de Bordeaux, 33000 Bordeaux (FR); Institut Polytechnique de Bordeaux, 33402 Talence Cedex (FR)
(72) Inventeur: NAVARRO, Christophe, F-64100 Bayonne (FR); SMAAL, Wiljan, F-33400 Talence (FR); MUMTAZ, Muhammad, F-33300 Bordeaux (FR); CLOUTET, Eric, F-33130 Begles (FR); BROCHON, Cyril, F-33700 Merignac (FR); HADZIIOANNOU, Georges, F-33850 Leognan (FR)
(74) Mandataire: Bonnel, Claudine
(86) Numéro de dépôt international: PCT/FR2014/052751
(87) Numéro de publication internationale: WO 2015/063417

(56) Documents cités:
- WO-A1-2013/150242

## Description

L'invention concerne des compositions stables de nanotubes de carbone et de polymères électrolytes, ces polymères électrolytes étant caractérisés par la présence de fonctions phosphonyle imide ou sulfonyle imide ou encore acide phosphorique. L'invention concerne également la fabrication d'électrodes transparentes comprenant ces compositions de nanotubes de carbone et de polymères électrolytes.

Les nanotubes de carbones (NTC) sont des matériaux très prometteurs dans des domaines aussi variés que les matériaux haute performance que l'électronique. Ils existent sous forme de nanotubes mono-paroi et multi-paroi. Malheureusement ils peuvent difficilement être utilisés seuls car ils se présentent sous forme d'agrégats, qui notamment ne permettent pas une transmission lumineuse lorsque par exemple on les dépose sur un support. Pourtant compte tenu de la taille des fibrilles de nanotubes et de leur conductivité intrinsèque, ils sont de bons candidats pour fabriquer des électrodes transparentes.

Les polymères électrolytes ont largement été utilisés dans des applications aussi variées que les batteries lithium comme conducteurs ioniques (K. Murata, S. Izuchi, Y. Yoshihisa, Electrochimica Acta 2000, 45, 1501), pour fabriquer des transistors organiques (A. Malti, M. Berggren, X. Crispin, Appl. Phys. Lett. 2012, 100, 183-302.), stabilizer des particules de magnétites (P. L. Golas, S. Louie, G. V. Lowry, K. Matyjaszewski, R. D. Tilton, Langmuir 2010, 26, 16890-16900), ou encore comme dopant et stabilisants pour la synthèse de polymères conducteurs (Louwet, F.;. Groenendaal, L.; Dhaen, J.; Manca, J.;. Luppen, J. V.; Verdonck, E.;. Leenders, L. Synth Met. 2003, 135-136, 115.).

La demanderesse à maintenant découvert que certaines combinaisons de monomères ioniques comprenant des fonctions phosphonyle imide ou sulfonyle imide ou encore acide phosphorique, sous forme d'homopolymères, de copolymères à bloc ou non, permettent une bonne dispersion des NTC dans des solutions aqueuses et que les films obtenus à l'aide de ces dispersion, une fois l'eau évaporée autorisent un très bon compromis transmission-conductivité.

### Résumé de l'invention :

L'invention concerne une composition comprenant des nanotubes de carbone et un (co)-polymère électrolyte, ce (co)-polymère électrolyte comprenant des monomères répondants à la formule I. 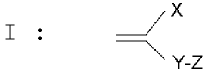 X = H, CH₃

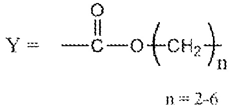

ou aryle

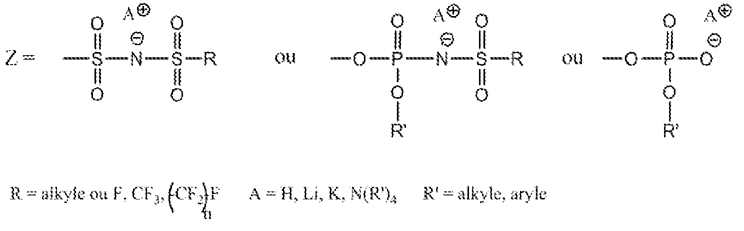

### Description détaillée :

Les nanotubes de carbone utilisés dans l'invention peuvent être mono, bi ou multiparoi.

Les (co) polymères électrolytes utilisés dans l'invention comprennent des entités répondant à la formule (I). Ce sont des homopolymères d'une entité répondant à la formule (I), des copolymères comprenant au moins une entité répondant à la formule (I) ou encore des copolymères à blocs dont au moins un des blocs comprend une ou plusieurs entités répondant à la formule (I).

Lorsque les polymères électrolytes sont des copolymères comprenant au moins une entité répondant à la formule (I) la proportion des entités répondant à la formule I représente plus de 50 % massique en poids du copolymère, de préférence plus de 80 % en poids, et de façon encore préférée plus de 90 % en poids. Les entités monomériques restantes étant constituées de tout type possible de monomères pouvant polymériser de façon radicalaire. Lorsque les polymères électrolytes sont des copolymères à blocs, il peut s'agir de copolymères di-blocs, triblocs, ou encore multiblocs, à condition qu'moins un des blocs comprend une ou plusieurs entités répondant à la formule (I), les autres blocs comprenant des monomères pouvant êtres choisis parmi les (meth)acrylates, typiquement l'acide acrylique ou méthacrylique, l'acrylamide, le méthacrylamide, le styrène, la N-vinyle-pyrrolidone, la 4-vinyle-pyrridine et plus précisément le méthacrylate de méthyle, l'acide méthacrylique et le styrène .

Toute chimie permettant la polymérisation radicalaire peut être utilisée qu'elle soit contrôlée ou non. De préférence on utilise la polymérisation radicalaire contrôlée par les nitroxydes ou la RAFT (radical addition fragmentation transfert) et de façon encore préférée la RAFT.

Ainsi, Selon un premier aspect de l'invention, la polymérisation radicalaire contrôlée se fait à partir des alcoxyamines dérivées du radical libre stable (1).

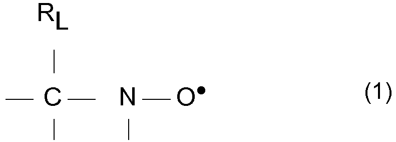

Dans laquelle le radical R_{L} présente une masse molaire supérieure à 15,0342 g/mole. Le radical R_{L} peut être un atome d'halogène tel que le chlore, le brome ou l'iode, un groupement hydrocarboné linéaire, ramifié ou cyclique, saturé ou insaturé tel qu'un radical alkyle ou phényle, ou un groupement ester -COOR ou un groupement alcoxyle -OR, ou un groupement phosphonate -PO(OR)₂, dès lors qu'il présente une masse molaire supérieure à 15,0342. Le radical R_{L}, monovalent, est dit en position β par rapport à l'atome d'azote du radical nitroxyde. Les valences restantes de l'atome de carbone et de l'atome d'azote dans la formule (1) peuvent être liées à des radicaux divers tels qu'un atome d'hydrogène, un radical hydrocarboné comme un radical alkyle, aryle ou aryle-alkyle, comprenant de 1 à 10 atomes de carbone. Il n'est pas exclu que l'atome de carbone et l'atome d'azote dans la formule (1) soient reliés entre eux par l'intermédiaire d'un radical bivalent, de façon à former un cycle. De préférence cependant, les valences restantes de l'atome de carbone et de l'atome d'azote de la formule (1) sont liées à des radicaux monovalents. De préférence, le radical R_{L} présente une masse molaire supérieure à 30 g/mole. Le radical R_{L} peut par exemple avoir une masse molaire comprise entre 40 et 450 g/mole. A titre d'exemple, le radical R_{L} peut être un radical comprenant un groupement phosphoryle, ledit radical R_{L} pouvant être représenté par la formule : 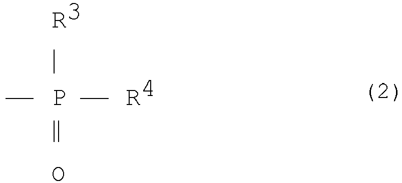 dans laquelle R³ et R⁴, pouvant être identiques ou différents, peuvent être choisis parmi les radicaux alkyle, cycloalkyle, alkoxyle, aryloxyle, aryle, aralkyloxyle, perfluoroalkyle, aralkyle, et peuvent comprendre de 1 à 20 atomes de carbone. R³ et/ou R⁴ peuvent également être un atome d'halogène comme un atome de chlore ou de brome ou de fluor ou d'iode. Le radical R_{L} peut également comprendre au moins un cycle aromatique comme pour le radical phényle ou le radical naphtyle, ce dernier pouvant être substitué, par exemple par un radical alkyle comprenant de 1 à 4 atomes de carbone.

Plus particulièrement les alcoxyamines dérivées des radicaux stables suivants sont préférées :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy,
- 2,4,6-tri-tert-butylphenoxy.

Les alkoxyamines utilisées en polymérisation radicalaire contrôlée doivent permettre un bon contrôle de l'enchaînement des monomères. Ainsi elles ne permettent pas toutes un bon contrôle de certains monomères. Par exemple les alcoxyamines dérivées du TEMPO ne permettent de contrôler qu'un nombre limité de monomères, il en va de même pour les alcoxyamines dérivées du 2,2,5-tri-methyl-4-phenyl-3-azahexane-3-nitroxyde (TIPNO). En revanche d'autres alcoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde permettent d'élargir à un grand nombre de monomère la polymérisation radicalaire contrôlée de ces monomères.
En outre la température d'ouverture des alcoxyamines influe également sur le facteur économique. L'utilisation de basses températures sera préférée pour minimiser les difficultés industrielles. On préférera donc les alkoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde à celles dérivées du TEMPO ou 2,2,5-tri-methyl-4-phenyl-3-azahexane-3-nitroxyde (TIPNO).

Selon un deuxième aspect de l'invention qui est le mode préféré, la polymérisation radicalaire contrôlée est effectuée par RAFT, et plus particulièrement à l'aide de l'agent RAFT répondant à la formule 2 suivante : 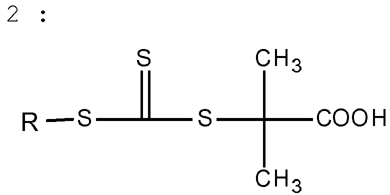 Ou R représente un groupement Alkyle comportant 1 à 22 atomes de carbone, et de préférence 10 à 18 atomes de carbone.

La synthèse de copolymères à blocs peut se faire en préparant d'abord le bloc poly-électrolyte macro-amorceur puis dans un deuxième temps les monomères du second bloc peuvent être polymérisés, accompagné éventuellement d'autres étapes de synthèse d'autres blocs prenant en compte d'autres monomères. On peut aussi préparer un bloc macro-initiateur par toute autre chimie (anionique, cationique, ouverture de cycle, polycondensation) incluant une ou deux terminaisons permettant l'amorçage ultérieur des monomères comprenant les entités (I).
On peut ainsi obtenir de nombreuses combinaisons telles que par exemple dans le cas de copolymères di-blocs, des di-blocs hydrophile- hydrophile, hydrophile-hydrophobe, anionique-neutre, anionique-anionique, anionique-cationique, cationique-neutres.

Ces polymères électrolytes sont utilement utilisés pour disperser des nanotubes de carbone mono ou multiparoi dans des proportions massiques polymères électrolytes-NTC variant de 1:10 à 10:1 et de préférence de 1:10 à 1:1. Les dispersions aqueuses de ces compositions sont stables. Elles peuvent être mise en forme en film fins par des techniques telles que le « spray coating », ou encore le « roll to roll » pour des grandes surfaces. Les films issus de ces préparations présentent une bonne conductivité électrique, une bonne transmission optique, une bonne stabilité thermique ainsi que de bonnes propriétés mécaniques. Ils peuvent avantageusement remplacer l'oxyde de titane et d'indium (ITO) en tant qu'électrode transparente dans les domaines de l'opto électronique et plus particulièrement les OLED (organic light emitting diodes) ou encore les cellule organiques photovoltaiques.

Ces polymères électrolytes peuvent aussi être utilisés seuls, c'est-à-dire sans NTC, dans la fabrication de membranes utiles pour les piles à combustible, comme conducteurs ioniques ou encore stabilisants de particules autres que les NTC.

## Revendications

1. Composition comprenant des nanotubes de carbone et un (co)-polymère électrolyte, ce (co)-polymère électrolyte comprenant des monomères répondants à la formule I. 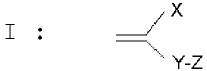
X = H, CH₃ 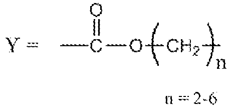
ou aryle

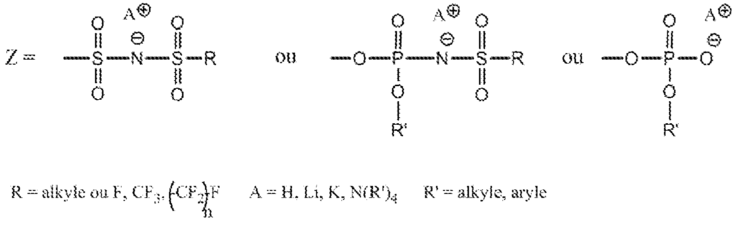

2. Composition selon la revendication 1 dans laquelle le (co) copolymère est un homopolymère

3. Composition selon la revendication 1 dans laquelle le (co) copolymère est un copolymère statistique.

4. Composition selon la revendication 1 dans laquelle le (co) copolymère est un copolymère à blocs.

5. Composition selon la revendication 1 dans laquelle les nanotubes de carbone sont monoparoi.

6. Composition selon la revendication 1 dans laquelle les nanotubes de carbone sont multiparoi.

7. Composition selon la revendication 1 dans laquelle les copolymères sont préparés par polymérisation radicalaire contrôlée.

8. Composition selon la revendication 7 dans laquelle les copolymères sont préparé par polymérisation radicalaire contrôlée par les nitroxydes.

9. Composition selon la revendication 8 dans laquelle le nitroxyde est le N-tertiobutyl-1-diéthylphosphono-2,2-diméthyl propyl nitroxyde.

10. Composition selon la revendication 7 dans laquelle les copolymères sont préparés par polymérisation radicalaire contrôlée par RAFT.

11. Composition selon la revendication 10 dans laquelle l'agent RAFT répond à la formule la formule 2 suivante : 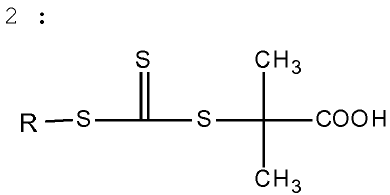 Ou R représente un groupement Alkyle comportant 1 à 22 atomes de carbones.

12. Electrode transparente conductrice obtenu à l'aide d'une composition selon une des revendications 1 à 11.

13. Utilisation de l'électrode transparente selon la revendication 12 dans les domaines des OLED (organic light emitting diodes) ou encore dans les cellules organiques photovoltaiques.

## Patentansprüche

1. Zusammensetzung, umfassend Kohlenstoff-Nanoröhren und ein Elektrolyt-(Co)-Polymer, wobei das Elektrolyt-(Co)-Polymer Monomere umfasst, die der Formel I entsprechen. 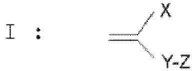
X = H, CH₃ 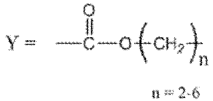
oder Aryl

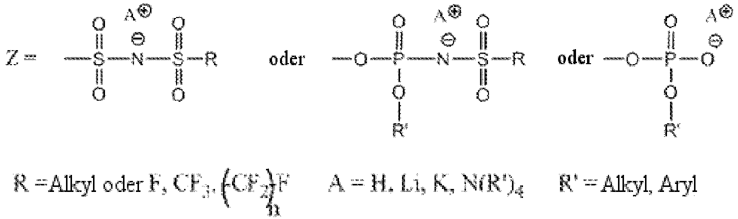

2. Zusammensetzung nach Anspruch 1, wobei das (Co)Polymer ein Homopolymer ist.

3. Zusammensetzung nach Anspruch 1, wobei das (Co)Polymer ein statistisches Copolymer ist.

4. Zusammensetzung nach Anspruch 1, wobei das (Co)Polymer ein Blockcopolymer ist.

5. Zusammensetzung nach Anspruch 1, wobei die Kohlenstoff-Nanoröhren einwandig sind.

6. Zusammensetzung nach Anspruch 1, wobei die Kohlenstoff-Nanoröhren mehrwandig sind.

7. Zusammensetzung nach Anspruch 1, wobei die Copolymere durch kontrollierte radikalische Polymerisation hergestellt werden.

8. Zusammensetzung nach Anspruch 7, wobei die Copolymere durch radikalische Polymerisation, die durch Nitroxide kontrolliert wird, hergestellt werden.

9. Zusammensetzung nach Anspruch 8, wobei es sich bei dem Nitroxid um N-tert-Butyl-1-diethylphosphono-2,2-dimethylpropylnitroxid handelt.

10. Zusammensetzung nach Anspruch 7, wobei die Copolymere durch radikalische Polymerisation, die durch RAFT kontrolliert wird, hergestellt werden.

11. Zusammensetzung nach Anspruch 10, wobei das RAFT-Mittel der folgenden Formel 2 entspricht: 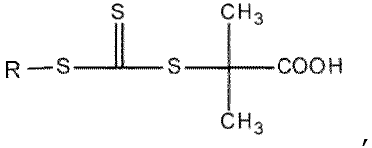 worin R eine Alkylgruppe mit 1 bis 22 Kohlenstoffatomen darstellt.

12. Transparente leitfähige Elektrode, die mithilfe einer Zusammensetzung nach einem der Ansprüche 1 bis 11 erhalten wird.

13. Verwendung der transparenten Elektrode nach Anspruch 12 auf dem Gebiet der organischen Leuchtdioden (OLED, engl.: organic light emitting diodes) oder auch in organischen photovoltaischen Zellen.

## Claims

1. Composition comprising carbon nanotubes and an electrolytic (co)polymer, this electrolytic (co)polymer comprising monomers corresponding to formula I. 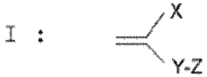
X = H, CH₃ 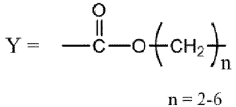
or aryl

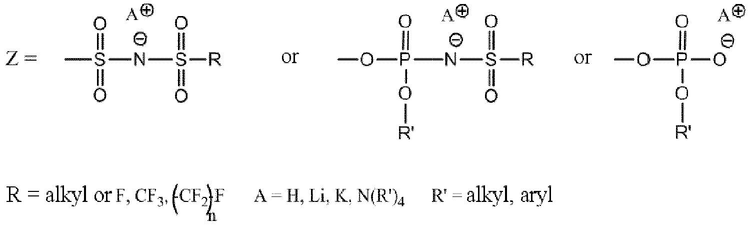

2. Composition according to Claim 1, in which the (co)polymer is a homopolymer.

3. Composition according to Claim 1, in which the (co)polymer is a statistical copolymer.

4. Composition according to Claim 1, in which the (co)polymer is a block copolymer.

5. Composition according to Claim 1, in which the carbon nanotubes are single-walled.

6. Composition according to Claim 1, in which the carbon nanotubes are multi-walled.

7. Composition according to Claim 1, in which the copolymers are prepared by controlled radical polymerization.

8. Composition according to Claim 7, in which the copolymers are prepared by nitroxide-controlled radical polymerization.

9. Composition according to Claim 8, in which the nitroxide is N-tert-butyl-1-diethylphosphono-2,2-dimethylpropyl nitroxide.

10. Composition according to Claim 7, in which the copolymers are prepared by RAFT-controlled radical polymerization.

11. Composition according to Claim 10, in which the RAFT agent corresponds to formula 2 below: 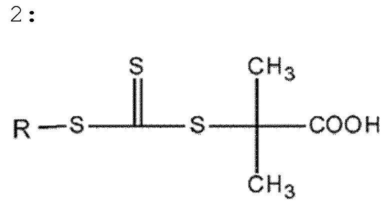 in which R represents an alkyl group comprising 1 to 22 carbon atoms.

12. Conductive transparent electrode obtained using a composition according to one of Claims 1 to 11.

13. Use of the transparent electrode according to Claim 12 in the fields of OLEDs (organic light-emitting diodes) or in photovoltaic organic cells.
